# EUROPÄISCHE PATENTSCHRIFT

(11) **EP 2 595 185 B1**
(45) Veröffentlichungstag und Bekanntmachung des Hinweises auf die Patenterteilung: **20.01.2016**
(21) Anmeldenummer: 12004724.6
(22) Anmeldetag: 21.06.2012
(51) Int. Cl.: H01L 23/495

(54) **Vorrichtung mit einem integrierten Schaltkreis**
Device with an integrated circuit
Dispositif avec un circuit intégré

(30) Priorität: 21.11.2011 DE 102011118932
(43) Veröffentlichungstag der Anmeldung: 22.05.2013
(73) Patentinhaber: Micronas GmbH, 79108 Freiburg (DE)
(72) Erfinder: Scholten, Gerd, 81369 München (DE)
(74) Vertreter: Koch Müller Patentanwaltsgesellschaft mbH

(56) Entgegenhaltungen:
- US-A1- 2007 007 631
- US-B1- 6 378 514

## Beschreibung

Die Erfindung betrifft eine Vorrichtung mit einem integrierten Schaltkreis gemäß dem Oberbegriff des Patentanspruchs 1.

Aus der JP 57118661 A Ist eine Vorrichtung mit einem integrierten Schaltkreis bekannt. Die Vorrichtung weist einen in einen Schaltkreisgehäuse eingebauten integrierten Schaltkreis, mehrere Anschlusskontakte und einen in das Schaltkreisgehäuse integrierten diskreten Kondensator auf. Hierbei sind ein erster Anschlusskontakt für die Spannungsversorgung und ein zweiter Anschlusskontakt mit einem Bezugspotential verschaltet.

Des Weiteren ist aus der Druckschrift DE 101 02 440 C1 ein Schaltkreisgehäuse für eine integrierte Schaltung und einen zusätzlich in das Schaltkreisgehäuse integrierten diskreten Kondensator bekannt. Ferner sind aus der US 2007 / 007631 A1 und der US 6378 514 B1 weitere Schaltungsanordnungen und Gehäuse bekannt.

Vor diesem Hintergrund besteht die Aufgabe der Erfindung darin, eine Vorrichtung anzugeben, die den Stand der Technik weiterbildet.

Die Aufgabe wird durch eine Vorrichtung mit den Merkmalen des Patentanspruchs 1 gelöst. Vorteilhafte Ausgestaltung der Erfindung ist in dem Unteranspruch enthalten.

Gemäß dem Gegenstand der Erfindung wird eine Vorrichtung bereitgestellt, aufweisend einen integrierten Schaltkreis und ein Schaltkreisgehäuse mit einem ersten Anschlusskontakt und einem zweiten Anschlusskontakt und einem dritten Anschlusskontakt, wobei der erste Anschlusskontakt und der zweite Anschlusskontakt und der dritte Anschlusskontakt aus dem Schaltkreisgehäuse herausgeführt sind, und der erste Anschlusskontakt als Spannungsversorgungsanschluss und der zweite Anschlusskontakt als Bezugspotentialanschluss ausgebildet ist und der erste Anschlusskontakt und der zweite Anschlusskontakt innerhalb des Schaltkreisgehäuses mit dem integrierten Schaltkreis verbunden sind und der dritte Anschlusskontakt im Schaltkreisgehäuse als Signalübertragungsanschluss mit dem integrierten Schaltkreis verschaltet ist, sowie einen ersten Kondensator und einen zweiten Kondensator, wobei der erste Kondensator und der zweite Kondensator in das Schaltkreisgehäuse integriert sind und der erste Kondensator an den ersten Anschlusskontakt und der zweite Kondensator an den dritten Anschlusskontakt angeschlossen ist, wobei ein vierter Anschlusskontakt und ein fünfter Anschlusskontakt vorgesehen sind und der vierte Anschlusskontakt und der fünfte Anschlusskontakt jeweils aus dem Schaltkreisgehäuse herausgeführt sind, und der erste Kondensator an den vierten Anschlusskontakt und der zweite Kondensator an den fünften Anschlusskontakt angeschlossen sind.

Es sei angemerkt, dass der erste Kondensator eine Verbindung zwischen dem ersten Anschlusskontakt und dem vierten Anschlusskontakt bildet. Weiterhin bildet der zweite Kondensator eine Verbindung zwischen dem dritten Anschlusskontakt und dem fünften Anschlusskontakt. Ferner handelt es sich jeweils bei dem ersten Anschlusskontakt, dem zweiten Anschlusskontakt, dem dritten Anschlusskontakt, dem vierten Anschlusskontakt und dem fünften Anschlusskontakt um unterschiedliche Anschlusskontakte.

Ein Vorteil ist, dass durch die Integration von Kondensatoren, welche nicht bereits mit dem jeweiligen zweiten Anschluss des jeweiligen Kondensators mit einem Bezugspotential, vorzugsweise mit dem Massepotential, verschaltet sind, sich zusätzliche Anwendungen für die Vorrichtung erschließen lassen, ohne dass sich eine Integration der Kondensatoren auf das Messprogramm bzw. die Messroutinen auswirken. Durch die vorteilhafte Anschlussweise der Kondensatoren werden die Messzeiten an den Anschlusskontakten der Versorgungsspannung und dem Bezugspotential insbesondere bei einem Final Test der Schaltkreise bei einem Vergleich zu den Messzeiten der jeweiligen Anschlusskontakte ohne angeschlossene integrierte Kondensatoren nicht verlängert. Auch werden bei Messungen im hochfrequenten Bereich, beispielsweise oberhalb 1 MHz, die Messergebnisse durch die integrierten Kondensatoren nicht verfälscht. Des Weiteren lassen sich die integrierten Kondensatoren sowohl vor, als auch nach der Final Testmessung noch mit dem Bezugspotential als auch mit weiteren externen Schaltungskomponenten verbinden. Indem vorliegend zusätzlich frei konfigurierbare Anschlusskontakte eingefügt werden, lässt sich die Flexibilität der Vorrichtung erheblich steigern.

In einer nicht beanspruchten Ausführungsform besteht zwischen dem vierten Anschlusskontakt und dem integrierten Schaltkreis innerhalb des Schaltkreisgehäuses kein elektrischer Anschluss. Gemäß einer anderen Ausführungsform ist zwischen dem fünften Anschlusskontakt und dem integrierten Schaltkreis innerhalb des Schaltkreisgehäuses kein elektrischer Anschluss ausgebildet. Ein Vorteil der beiden vorangestellten Ausführungsformen, d.h. mittels des einseitigen Anschlusses besteht darin, dass ein Test des integrierten Schaltkreises, ohne Auswirkungen auf den integrierten Schaltkreis durch die Integration des ersten Kondensators und oder des zweiten Kondensators durchführen lässt. Hierzu wird in einem ersten Schritt ausschließlich der erste Anschlusskontakt und / oder der zweite Anschlusskontakt und / oder der dritte Anschlusskontakt an eine Testeinrichtung angeschlossen.

In einer Weiterbildung ist die Vorrichtung dadurch gekennzeichnet, dass der vierte Anschlusskontakt zwischen dem ersten Anschlusskontakt und dem zweiten Anschlusskontakt angeordnet ist, und der fünfte Anschlusskontakt zwischen dem zweiten Anschlusskontakt und dem dritten Anschlusskontakt angeordnet ist. Ein Vorteil der Anordnung liegt in einer einfachen Verbindungsmöglichkeit des zweiten als Bezugspotentialanschluss ausgeführten Anschlusskontakts mit dem vierten Anschlusskontakt und / oder dem fünften Anschlusskontakt. Durch das unmittelbare Aufeinanderfolgen der drei Anschlusskontakte lassen sich beispielsweise einfache gerade Drahtabschnitte oder Drahtbrücken zu einem Verbinden der unmittelbar benachbarten Anschlusskontakte verwenden, ohne eine Ausbildung von speziell geformten Drähten für ein Ausblenden von nicht zu verbindenden Anschlusskontakten.

Gemäß einer erfindungsgemäßen Ausführungsform sind der zweite Anschlusskontakt und der vierte Anschlusskontakt und der fünfte Anschlusskontakt außerhalb des Schaltkreisgehäuses in einem ersten Drittel der außerhalb des Schaltkreisgehäuses ausgebildeten Gesamtlänge der Anschlusskontakten miteinander kurzgeschlossen. Alternativ oder zusätzlich sind der zweite Anschlusskontakt und der vierte Anschlusskontakt und der fünfte Anschlusskontakt außerhalb des Schaltkreisgehäuses in einem dritten Drittel der außerhalb des Schaltkreisgehäuses ausgebildeten Gesamtlänge der Anschlusskontakten miteinander kurzgeschlossen.

Ein besonderer Vorteil der Ausführungsformen ist es, dass durch das Verbinden der Anschlusskontakte eine andere Funktionalität der Vorrichtung Im Vergleich zu den vorhergehenden Weiterbildungen entsteht. Die andere Funktionalität besteht beispielsweise darin, dass die integrierten Kondensatoren, im Gegensatz zum Testbetrieb, d.h. in einem Betrieb mit nur einseitig angeschlossenen Kondensatoren, die Kondensatoren nunmehr als Entstörfilter auf die Versorgungsspannung wirken. Vorteilhaft ist dabei, dass sich die Funktionalität jederzeit herstellen lässt. Untersuchungen haben gezeigt, dass sich die Vorrichtung ohne den Kurzschluss, des zweiten Anschlusskontaktes und des vierten Anschlusskontaktes und des fünften Anschlusskontaktes ausliefern lässt und hierdurch einem Anwender eine hohe schaltungstechnische Flexibilität zur Verfügung stellt. Besonders vorteilhaft ist hierbei, dass bei der Herstellung trotz der Einführung von zwei zusätzlichen Anschlusskontakten eine Kosteneinsparung mittels eines reduzierten Aufwandes bei dem Test der Schaltkreise entsteht.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine schematische Ansicht auf eine nicht beanspruchte Ausführungsform der Vorrichtung,
- Figur 2: eine schematische Ansicht auf eine erfindungsgemäße Ausführungsform der Vorrichtung,
- Figur 3: eine schematische Ansicht auf eine weitere erfindungsgemäße Ausführungsform der Vorrichtung,
- Figur 4: eine schematische Ansicht auf nicht beanspruchte Ausführungsform der Vorrichtung,
- Figur 5: eine schematische Ansicht auf eine Vorrichtung gemäß dem Stand der Technik.

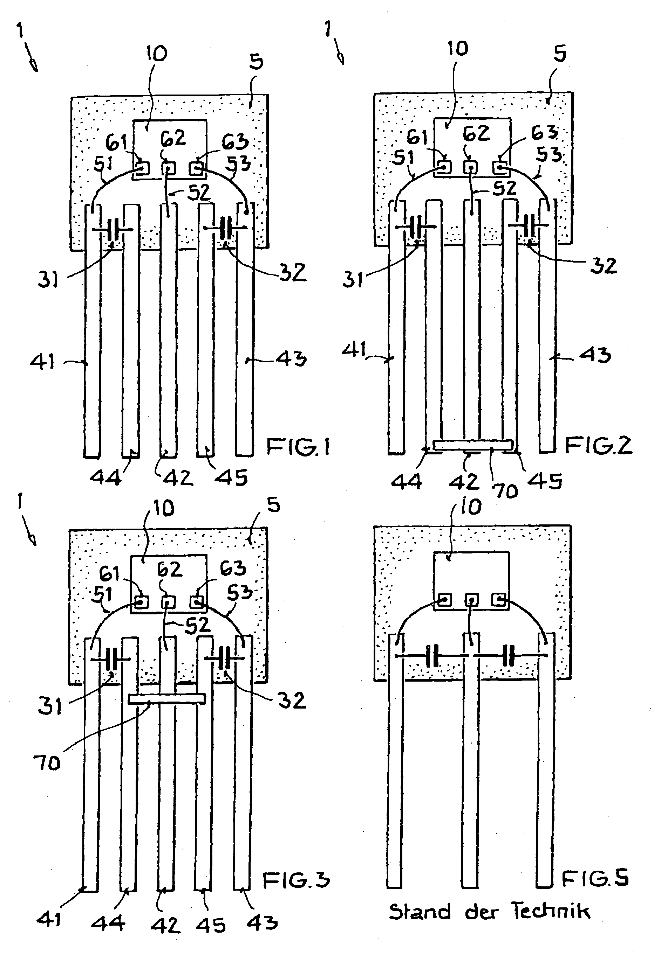

Die Abbildung der Figur 1 zeigt eine schematische Ansicht einer nicht beanspruchten Ausführungsform einer Vorrichtung 1, aufweisend ein Schaltkreisgehäuse 5 und einen innerhalb des Schaltkreisgehäuses 5 integrierten Schaltkreis 10. Aus dem Schaltkreisgehäuse 5 sind ein erster Anschlusskontakt 41 und ein zweiter Anschlusskontakt 42 und ein dritter Anschlusskontakt 43 und ein vierter Anschlusskontakt 44 und ein fünfter Anschlusskontakt 45 herausgeführt. Die Anschlusskontakte 41, 42, 43, 44, 45 sind in einer Reihe und parallel zueinander angeordnet. Auf den ersten Anschlusskontakt 41 folgt, von links nach rechts, der vierte Anschlusskontakt 44, hiernach der zweite Anschlusskontakt 42, hiernach der fünfte Anschlusskontakt 45 und als letztes der dritte Anschlusskontakt 43. Der erste Anschlusskontakt 41 ist im Schaltkreisgehäuse 5 über einen ersten Bonddraht 51 an eine erste Kontaktfläche 61 auf dem integrierten Schaltkreis 10 angeschlossen. Der zweite Anschlusskontakt 42 ist im Schaltkreisgehäuse 5 über einen zweiten Bonddraht 52 an eine zweite Kontaktfläche 62 auf dem integrierten Schaltkreis 10 angeschlossen. Der dritte Anschlusskontakt 43 ist im Schaltkreisgehäuse 5 über einen dritten Bonddraht 53 an eine dritte Kontaktfläche 63 auf dem integrierten Schaltkreis 10 angeschlossen. In das Schaltkreisgehäuse sind außerdem ein erster Kondensator 31 und ein zweiter Kondensator 32 integriert. Der erste Kondensator 31 ist an den ersten Anschlusskontakt 41 und an den vierten Anschlusskontakt 44 angeschlossen. Der zweite Kondensator 32 ist an den dritten Anschlusskontakt 43 und an den fünften Anschlusskontakt 45 angeschlossen.

In der Abbildung der Figur 2 ist eine erfindungsgemäße Ausführungsform der Vorrichtung 1 dargestellt. Im Folgenden werden nur die Unterschiede zu der Abbildung der Figur 1 erläutert. Am unteren Ende, d.h. im dritten Drittel der Anschlusskontakte 42, 44, 45 ist eine Drahtbrücke 70 rechtwinklig zwischen den Anschlusskontakten 42, 44, 45 ausgebildet. Die Drahtbrücke 70 stellt einen Kurzschluss zwischen dem vierten Anschlusskontakt 44, dem dritten Anschlusskontakt 43 und dem fünften Anschlusskontakt 45 her.

In der Abbildung der Figur 3 ist eine weitere erfindungsgemäße Ausführungsform der Vorrichtung 1 dargestellt. Im Folgenden werden nur die Unterschiede zu der Abbildung der Figur 1 erläutert. Außerhalb des Schaltkreisgehäuses 5, unmittelbar an der Stelle der Herausführung der Anschlusskontakte 42, 44, 45, d.h. in einem ersten Drittel, ist eine Drahtbrücke 70 parallel zu dem Schaltkreisgehäuse 5 ausgebildet. Die Drahtbrücke 70 stellt einen Kurzschluss zwischen dem vierten Anschlusskontakt 44, dem dritten Anschlusskontakt 43 und dem fünften Anschlusskontakt 45 her und ist beispielsweise aus einem Metallstreifen ausgebildet. Der Metallstreifen ist beispielsweise durch eine Lötung mit dem zweiten Anschlusskontakt 42 und dem vierten Anschlusskontakt 44 und dem fünften Anschlusskontakt 45 unmittelbar verbunden.

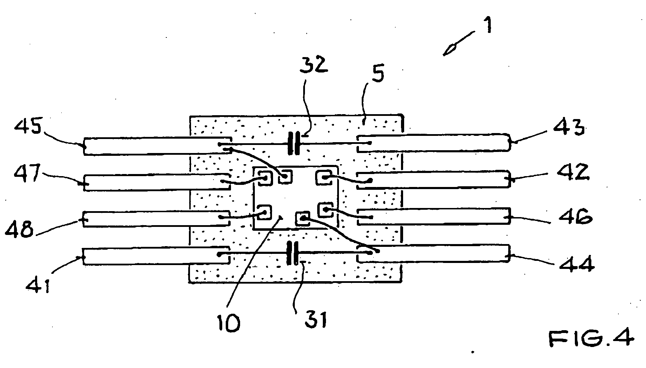

In der Abbildung der Figur 4 ist eine weitere nicht beanspruchte Ausführungsform der Vorrichtung 1 dargestellt. Im Folgenden werden nur die Unterschiede zu der Abbildung der vorangegangen Figuren erläutert. Demgemäß wird eine weitere Form des Schaltkreisgehäuses 5 angeführt. Das Schaltkreisgehäuse 5 weist nunmehr einen sechsten Anschlusskontakt 46, einen siebten Anschlusskontakt 47 und einen achten Anschlusskontakt 48 auf. Ferner sind die Anschlusskontakte 41, 48, 47 und 45 in Bezug auf die Anschlusskontakte 44, 46, 42 und 43 auf gegenüberliegenden Seiten des Schaltkreisgehäuses 5 angeordnet. Die zusätzlichen Anschlusskontakte 46, 47, 48 sind bevorzugt als Signalanschlüsse für integrierten Schaltkreis 10 ausgeführt.

Es versteht sich, dass die Anschlusskontakte je nach Ausführung der Schaltkreisgehäuse ganz unterschiedlich und nicht in einer Reihe angeordnet sind. Demgemäß lassen sich auch in weiteren Schaltkreisgehäusen Kondensatoren und insbesondere auch weitere passive Bauelemente mit zusätzlichen Anschlusskontakten entsprechend der vorliegenden erfinderischen Idee in das Schaltkreisgehäuse integrieren.

In der Figur 5 ist eine Vorrichtung nach dem Stand der Technik, wie bereits in der Beschreibungseinleitung erwähnt, in abstrahierter Form abgebildet.

### Bezugszeichenliste

- 1: Vorrichtung
- 5: Schaltkreisgehäuse
- 10: integrierter Schaltkreis, Halbleiterchip
- 31: Erster Kondensator
- 32: Zweiter Kondensator
- 41: Erster Anschlusskontakt
- 42: Zweiter Anschlusskontakt
- 43: Dritter Anschlusskontakt
- 44: Vierter Anschlusskontakt
- 46: Sechster Anschlusskontakt
- 47: Siebter Anschlusskontakt
- 48: Achter Anschlusskontakt
- 45: Fünfter Anschlusskontakt
- 51: Erster Bonddraht
- 52: Zweiter Bonddraht
- 53: Dritter Bonddraht
- 61: Erste Kontaktfläche
- 62: Zweite Kontaktfläche
- 63: Dritte Kontaktfläche
- 70: Drahtbrücke

## Patentansprüche

1. Vorrichtung (1) aufweisend,
einen integrierten Schaltkreis (10) und ein Schaltkreisgehäuse (5) mit einem ersten Anschlusskontakt (41) und einem zweiten Anschlusskontakt (42) und einem dritten Anschlusskontakt (43), wobei der erste Anschlusskontakt (41) und der zweite Anschlusskontakt (42) und der dritte Anschlusskontakt (43) aus dem Schaltkreisgehäuse (5) herausgeführt sind, und der erste Anschlusskontakt (41) als Spannungsversorgungsanschluss und der zweite Anschlusskontakt (42) als Bezugspotentialanschluss ausgebildet ist und der erste Anschlusskontakt (41) und der zweite Anschlusskontakt (42) innerhalb des Schaltkreisgehäuses (5) mit dem integrierten Schaltkreis (10) verbunden sind und der dritte Anschlusskontakt (43) im Schaltkreisgehäuse (5) als Signalübertragungsanschluss mit dem integrierten Schaltkreis (10) verschaltet ist, sowie einen ersten Kondensator (31) und einen zweiten Kondensator (32), wobei der erste Kondensator (31) und der zweite Kondensator (32) in das Schaltkreisgehäuse (5) integriert sind und der erste Kondensator (31) an den ersten Anschlusskontakt (41) und der zweite Kondensator (32) an den dritten Anschlusskontakt (43) angeschlossen ist, und
ein vierter Anschlusskontakt (44) und ein fünfter Anschlusskontakt (45) vorgesehen sind und der vierte Anschlusskontakt (44) und der fünfte Anschlusskontakt (45) jeweils aus dem Schaltkreisgehäuse (5) herausgeführt sind, und
der erste Kondensator (31) an den vierten Anschlusskontakt (44) und der zweite Kondensator (32) an den fünften Anschlusskontakt (46) angeschlossen sind,
**dadurch gekennzeichnet, dass**
der zweite Anschlusskontakt (42) und der vierte Anschlusskontakt (44) und der fünfte Anschlusskontakt (45) außerhalb des Schaltkreisgehäuses (5) in einem dritten Drittel der außerhalb des Schaltkreisgehäuses (5) ausgebildeten Gesamtlänge der Anschlusskontakten (42, 44, 45) miteinander kurzgeschlossen sind.

2. Vorrichtung (1) nach Anspruch 1, **dadurch gekennzeichnet, dass** der Kurzschluss in einem ersten Drittel erfolgt.

## Claims

1. Device (1) comprising an integrated circuit (10) and a circuit housing (5) with a first terminal contact (41) and a second terminal contact (42) and a third terminal contact (43), wherein the first terminal contact (41) and the second terminal contact (42) and the third terminal contact (43) are led out of the circuit housing (5) and the first terminal contact (41) is constructed as a voltage supply terminal and the second terminal contact (42) as a reference potential terminal and the first terminal contact (41) and the second terminal contact (42) are connected within the circuit housing (5) with the integrated circuit (10) and the third terminal contact (43) is connected, as a signal transmission terminal, in the circuit housing (5) with the integrated circuit (10), as well as a first capacitor (31) and a second capacitor (32), wherein the first capacitor (31) and the second capacitor (32) are integrated in the circuit housing (5) and the first capacitor (31) is connected with the first terminal contact (41) and the second capacitor (32) with the third terminal contact (43), and a fourth terminal contact (44) and a fifth terminal contact (45) are provided and the fourth terminal contact (44) and the fifth terminal contact (45) are each led out of the circuit housing (5) and the first capacitor (31) is connected with the fourth terminal contact (44) and the second capacitor (32) is connected with the fifth terminal contact (46), **characterised in that** the second terminal contact (42) and the fourth terminal contact (44) and the fifth terminal contact (45) are short-circuited outside the circuit housing (5) in a 3rd third of the total length, which is formed outside the circuit housing (5), of the terminal contacts (42, 44, 45).

2. Device (1) according to claim 1, **characterised in that** the short-circuit is effected in a 1 st third.

## Revendications

1. Dispositif (1) présentant
- un circuit intégré (10) et un boîtier de circuit (5) avec un premier contact de raccordement (41) et un deuxième contact de raccordement (42) et un troisième contact de raccordement (43), dans lequel le premier contact de raccordement (41) et le deuxième contact de raccordement (42) et le troisième contact de raccordement (43) sont menés hors du boîtier de circuit (5) et le premier contact de raccordement (41) est réalisé sous forme de raccordement d'alimentation de tension et le deuxième contact de raccordement (42) est réalisé sous forme de raccordement de potentiel de référence et le premier contact de raccordement (41) et le deuxième contact de raccordement (42) sont reliés au circuit intégré (10) à l'intérieur du boîtier de circuit (5) et le troisième contact de raccordement (43) est connecté dans le boîtier de circuit (5) sous forme de raccordement de transmission de signal avec le circuit intégré (10), ainsi qu'un premier condensateur (31) et un deuxième condensateur (32), dans lequel le premier condensateur (31) et le deuxième condensateur (32) sont intégrés dans le boîtier de circuit (5) et le premier condensateur (31) est raccordé au premier contact de raccordement (41) et le deuxième condensateur (32) est raccordé au troisième contact de raccordement (43) et
- il est prévu un quatrième contact de raccordement (44) et un cinquième contact de raccordement (45) et le quatrième contact de raccordement (44) et le cinquième contact de raccordement (45) sont menés respectivement hors du boîtier de circuit (5) et
- le premier condensateur (31) est raccordé au quatrième contact de raccordement (44) et le deuxième condensateur (32) est raccordé au cinquième contact de raccordement (45),
**caractérisé en ce que**
- le deuxième contact de raccordement (42) et le quatrième contact de raccordement (44) et le cinquième contact de raccordement (45) sont court-circuités entre eux à l'extérieur du boîtier de circuit (5) dans un troisième tiers de la longueur totale des contacts de raccordement (42, 44, 45) formée à l'extérieur du boîtier de circuit (5).

2. Dispositif (1) selon la revendication 1, **caractérisé en ce que** le court-circuit est réalisé dans un premier tiers.
